(19) Europäisches Patentamt
European Patent Office
Office européen des brevets

(11) **EP 3 301 461 A1**

(12) **EUROPEAN PATENT APPLICATION**

(43) Date of publication:
04.04.2018 Bulletin 2018/14

(51) Int Cl.:
*G01R 19/25* (2006.01)     *G06F 17/14* (2006.01)

(21) Application number: 16191144.1

(22) Date of filing: 28.09.2016

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(71) Applicant: Siemens Aktiengesellschaft
80333 München (DE)

(72) Inventors:
• **Faisal Aftab, Muhammad**
7031 Trondheim (NO)
• **Hovd, Morten**
7058 Jakkobsli (NO)
• **Sivalingam, Selvanathan**
7044 Trondheim (NO)

(74) Representative: **Maier, Daniel Oliver**
Siemens AG
Postfach 22 16 34
80506 München (DE)

(54) **METHOD FOR DETECTION OF HARMONICS OF A UNIVARIATE SIGNAL**

(57)    The invention relates to a method for detection of harmonics of a univariate signal (X), comprising the steps of:
making (S100) at least a trivariate signal (Y) with at least three channels by appending the univariate signal (X) with at least two channel zero mean uncorrelated Gaussian noise,
decomposing (S200) each channel into N components (IMF) by processing the signal (Y) using multivariate empirical mode decomposition (MEMD),
calculating (S300) the Auto covariance function (ACF) of the components (IMF),
analysing (S400) the Auto covariance functions (ACF) to determine zero crossings of each Auto covariance function (ACF) and determine mean time periods (Tp) of the oscillations,
calculating (S500) at least one base frequency ('Ω) using the mean time period (TP), and calculate at least one maximum frequency ('$\Omega_{max}$) and a minimum frequency ('$\Omega_{min}$), using at least the base frequency ('Ω), and
identifying (S600) whose component (IMF'), which has the largest correlation with the signal (X).

FIG 2

EP 3 301 461 A1

**Description**

The invention relates to the detection of harmonics of a univariante signal.

Non-linearity induced oscillations exhibit higher order harmonics in the frequency domain. Hence the presence of harmonics can give a vital clue towards the possible root cause of the oscillations. Mostly the harmonic detection is carried out manually and a comprehensive method to automatically detect the presence of harmonics is absent.

Naveed Ur Rehman and Danilo P Mandic disclose in the article Filter bank property of multivariate empirical mode decomposition (Signal Processing, IEEE Transactions on Signal Processing 59(5), 2421 - 2426, 2011) that the multivariate empirical mode decomposition MEMD) algorithm follows a filter bank structure (channel wise) for a multivariate white noise input. It has also been shown that MEMD aligns similar modes present across multiple channels in same-index IMFs, which is difficult to obtain by applying standard EMD channel wise. Furthermore, by using the property of MEMD to behave as a filter bank in the presence of white noise, it is proposed a noise-assisted MEMD (N-A MEMD) algorithm, whereby by introducing extra channels of multivariate noise, the effects of mode mixing and mode misalignment in multivariate IMFs have been reduced. However, high-frequency components were still present in the estimated signal.

Therefore, the object of the invention is to provide an improved method for detection of harmonics of a univariate signal.

That object of the invention is solved by a method for detection of harmonics of a univariate signal, comprising the steps of:

making at least a trivariate signal with at least three channels by appending the univariate signal with at least two channel zero mean uncorrelated Gaussian noise,

decomposing each channel into N components by processing the signal using multivariate empirical mode decomposition (MEMD),

calculating the Auto covariance function of the components,

analysing the Auto covariance functions to determine zero crossings of each Auto covariance function and determine mean time periods of the oscillations,

calculating at least one base frequency using the mean time period, and calculate at least one maximum frequency and a minimum frequency using at least the base frequency, and

identifying whose component, which has the largest correlation with the signal.

The signal can be based on a time series of sampled measurements. Accordingly, the signal can be a time-discrete signal. The at least trivariate signal can also be considered as an at least three-dimensional signal. Gaussian noise is considered as statistical noise having a probability density function (PDF) equal to that of the normal distribution, which is also known as the Gaussian distribution. In other words, the values that the noise can take on are Gaussian-distributed.

The MEMD algorithm for the multivariate empirical mode decomposition (MEMD) is a generic extension of standard EMD for multivariate data process a general class of multivariate signals having an arbitrary number of channels. It extends the concept of bivariate EMD and trivariate EMD by processing the input signal directly in a multidimensional domain (n-space), where the signal resides. To achieve that, input signal projections are taken directly along different directions in n-dimensional spaces to calculate the local mean.

The components - also called IMF (Intrinsic Mode Function) - can be orthogonal, nearly orthogonal, or substantially orthogonal.

By analysing the Auto covariance functions to determine zero crossings of each Auto covariance function and determine mean time periods of the oscillations, calculating at least one base frequency using the mean time period, and calculate at least one maximum frequency and a minimum frequency using at least the base frequency it is possible to take the standard deviation of the determined time intervals between zero crossings into account. Next, correlations between the components and the input signal are calculated and compared to identify whose component with the largest correlation with the signal. That component is also called the fundamental IMF. By this way it is possible to remove undesired components from the signal resulting in an improvement of the detection of harmonics of a univariate signal.

Further, the method may comprise the step of

retaining the components corresponding to the signal and/or discard the components corresponding to the at least two noise channels.

Moreover, the method may comprise the step of

calculating correlation coefficients of each component with the corresponding signal,

calculating corresponding normalized correlation coefficients using the correlation coefficient,

comparing the normalized correlation coefficients with a threshold, and retain those components for which normalized correlation coefficients are equal or larger than the threshold,

determine a sparseness for all retained components, and compare each sparseness with a second threshold, and retain those components for which the sparseness is higher than the second threshold, and

calculating the Auto covariance function on the basis of the retained components.

Accordingly, those components are discarded for which normalized correlation coefficients are smaller than the first threshold. Moreover, those components are discarded for which sparseness is smaller than the second threshold. Thus, only best fitting normalized correlation coefficients are taking into account for calculating the Auto covariance function. Therefore, the performance of the method can be further improved.

Further, the method may comprise the step of:

determining the regularity of the oscillations by analysing at least the mean time period, and

comparing the regularity with a limit, and retain those mean time periods for which the regularity is greater than the limit.

Determining of the regularity may be based on considering an oscillation as regular if the standard deviation of the period is less than one third of the mean value, for example. As the limit a value of 1 can be taken since values for the regularity greater than 1 indicates that there is a regular oscillation with a well defined period.

Moreover, the method may comprise the step of:

multiply a corresponding frequency of the identified component with an integer,

take a respective maximum frequency and minimum frequency of another component, and compare the integer multiples with the respective maximum frequency and minimum frequency of the other component, and consider the frequency as harmonic, if the integer multiples lies within the respective maximum frequency and minimum frequency of the other component, and

comparing the correlation coefficients of the identified component with one correlation coefficient of at least one other component, and consider the identified component and the other component as harmonic pair, if the correlation coefficients of the identified component is higher than the correlation of the other component.

Thus, a kind of heuristic search is performed, whereby firstly the search is performed outside the interval defined by the firstly determined maximum frequency and a minimum frequency, and secondly the results are verified by comparing the respective correlation coefficients of the indentified component and the other component. If the correlation coefficient of the identified component is higher than the correlation coefficient of the other component, then the identified component and the other component are considered as harmonic pair, otherwise not, e.g. the another component relates to another oscillation.

Further, the method may comprise the step of

comparing the correlation coefficients of the other component with one correlation coefficient of one further other component, and consider the other
component and the other component as harmonic, if the correlation coefficients of the other component is higher than the correlation of the further other component.

Accordingly, also correlation coefficients of a further, other component can be taken for verification. Here, the correlation coefficient of the further, other component is compared with the correlation coefficient of the other component, and both components are considered as harmonic triple together with the identified component if the correlation coefficient the other component is higher than the correlation coefficient of the further, other component. If the correlation coefficient of the other component is not higher than the correlation coefficient of the further, other component, then the another component relates to another oscillation.

The above mentioned steps can be repeated for the next correlated component and so on. That means that the components are taken according to their decreasing correlation coefficients, to get the harmonics due to multiple sources.

Further, the object of invention is also solved by a software product and a device configured for performing such a method.

In the following the invention will be describe with reference to the accompanying drawings.

Fig. 1 shows a schematic flow chart of one example of a method according to the invention.

Fig. 2 shows a first simulation example.

Fig. 3 shows a second simulation example.

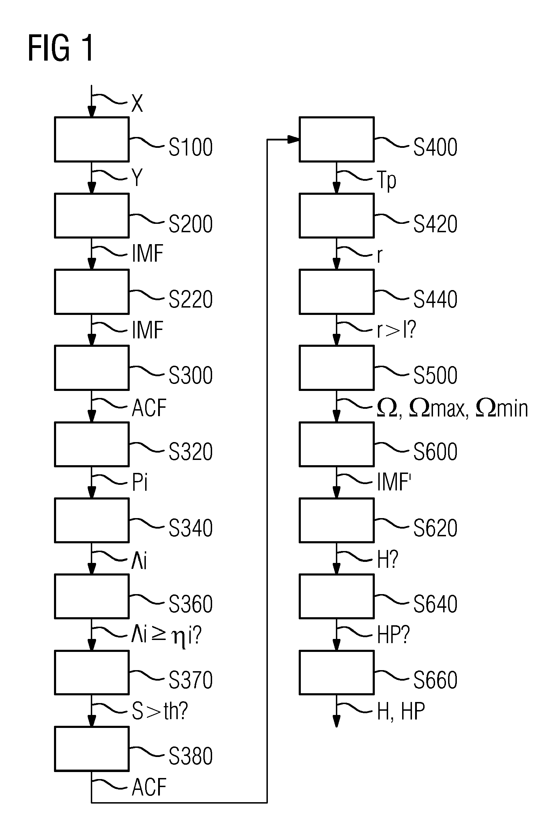

Reference is made to Fig. 1.

The method for detection of harmonics can be carried out on a device, for example a computer comprising hardware and/or software, processing a univariate signal X which was obtained by sampling a time series, for example measurements of values of a plant which should be controlled or EEG signals and/or EMG signals and/or EOG signals.

The method starts at step S100.

In the present embodiment of the invention at step S100 trivariate signal Y with three channels by appending the univariate signal with two channels zero mean uncorrelated Gaussian noise is made.

At step S200 each channel is decomposed into N components IMF by processing the signal Y using multivariate empirical mode decomposition MEMD. In the present embodiment that components IMF are orthogonal components. The components IMF may also by nearly orthogonal or substantially orthogonal components.

At step S220 the components IMF corresponding to the signal X are retained and the components IMF corresponding to the two noise channels are discarded.

At step S300 Auto covariance functions ACF of the components IMF are calculated. In the present embodiment the step S300 comprises the following sub-steps S320, S340, S360, and S380:

In step sub-step S320 correlation coefficients $\rho_i$ of each component IMF with the corresponding signal X are calculated using equation (1):

$$\rho_i = \frac{Cov(c_i, x)}{\sigma_x \sigma_{c_i}}, i = 1,2,3...N \qquad (1)$$

where Cov denotes the covariance, $\sigma_x$ and $\sigma_{ci}$ are the standard deviations of the signal X and the components IMF, respectively, and N is total number of components.

In sub-step S340 corresponding normalized correlation coefficients $\lambda_i$ using the correlation coefficient $\rho_i$ are calculated using equation (2):

$$\lambda_i = \frac{\rho_i}{\max(\rho_i)}, i = 1,2,3...N \qquad (2)$$

In sub-step S360 the normalized correlation coefficients $\lambda_i$ with a threshold $\eta$ is compared, and those components IMF are retained for which the normalized correlation coefficients $\lambda_i$ is equal or larger than the threshold ($\eta$): $\lambda_i \geq \eta_i$.

Additionally, in sub-step S370 the sparseness S will be calculated for all retained components IMF, from their frequency spectrum X up to Nyquist frequency using equation (3) :

$$S(x) = \frac{\sqrt{N} - \left( \sum \left| X_i \middle/ \sqrt{\sum |X_i|^2} \right| \right)}{\sqrt{N} - 1} \qquad (3)$$

Further, the sparseness S is compared with a threshold th and those components IMF are retained for which the sparseness S is higher than the threshold: S(x) > th.

In sub-step S380 the Auto covariance function ACF on the basis of the retained components IMF is calculated.

In step S400 the Auto covariance functions ACF is analysed to determine zero crossings of each Auto covariance function ACF and mean time periods Tp of the oscillations are determined using equation (4):

$$Tp = \frac{2}{n} \sum_{i=1}^{n} (\Delta t_i) \qquad (4)$$

In the present embodiment the step S400 comprises the following sub-steps S420 and S440:

In sub-step S420 the regularity r of the oscillations is determined by analysing at least the mean time period TP using equation (5):

$$r = \frac{1}{3} \frac{Tp}{\sigma_{Tp}} \qquad (5)$$

In sub-step S440 the regularity r is compared with a limit 1, which is in the present embodiment l = 1. Further, in sub-step S440 those mean time periods TP are retained for which the regularity r is greater than the limit l, e.g. r > 1.

In step S500 one base frequency 'Ω using the retained mean time period TP is calculated. Further one maximum frequency 'Ω$_{max}$ and a minimum frequency 'Ω$_{min}$ is calculated, using the base frequency 'Ω, for each component IMF with r > 1 using the equations (6), (7), and (8) :

$$\Omega = \frac{1}{T_p} \qquad (6)$$

$$\Omega_{max} = \frac{1}{T_p - \sigma_{Tp}} \qquad (7)$$

$$\Omega_{min} = \frac{1}{T_p + \sigma_{Tp}} \qquad (8)$$

In step S600 a component IMF is identified which has the largest correlation with the signal X. This may be the component with λ = 1 or lower and the corresponding frequency Ω$_{\lambda max}$, which may also called the fundamental IMF.

The step 600 may comprise further steps, for example to provide a confirmation that a harmonics is found. Therefore, the sub-steps S620, S640, and S660 are carried out in the present embodiment:

In sub-step S620 a corresponding frequency Ω$_{\lambda max}$ of the identified component IMF' will be multiplied with an integer k.

In sub-step S640 a respective maximum frequency and minimum frequency of another component IMF are taken, and the integer multiples are compared with the respective maximum frequency and minimum frequency of the other component IMF. The frequency is considered as harmonic, if the integer multiples lies within the respective maximum frequency and minimum frequency of the other component.

In sub-step S660 the correlation coefficients of the identified component IMF' are compared with one correlation coefficient of at least one other component IMF, and the identified component IMF' and the other component IMF are considered as harmonic pair HP, if the correlation coefficients of the identified component IMF' is higher than the correlation of the other component IMF.

Thus, a two-step search is performed. In the first step the search is performed outside the interval defined by the firstly determined maximum frequency 'Ω$_{max}$ and a minimum frequency 'Ω$_{min}$. In a second step results are verified by comparing the respective correlation coefficients of the indentified component IMF' and the other component. If the correlation coefficient of the identified component IMF' is higher than the correlation coefficient of the other component, then the identified component and the other component are considered as harmonic pair H, otherwise not, e.g. the another component relates to another oscillation. Further, also correlation coefficients of a further, other component can be taken for verification. Accordingly, the correlation coefficient of the further, other component representing a higher harmonic is compared with the correlation coefficient of the other component representing a lower harmonic, and both components are considered as harmonic triple together with the identified component if the correlation coefficient the other component is higher that the correlation coefficient of the further, other component. If the correlation coefficient of the other component is not higher than the correlation coefficient of the further, other component, then the another component relates to another oscillation.

The above mentioned steps can be repeated for the next most correlated component and so on. That means that the components are taken according to their decreasing correlation coefficients, to get the harmonics due to multiple sources.

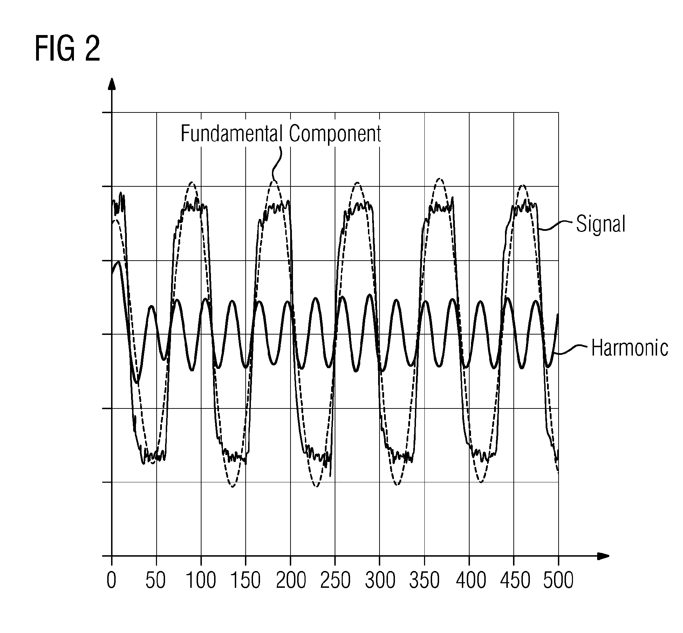

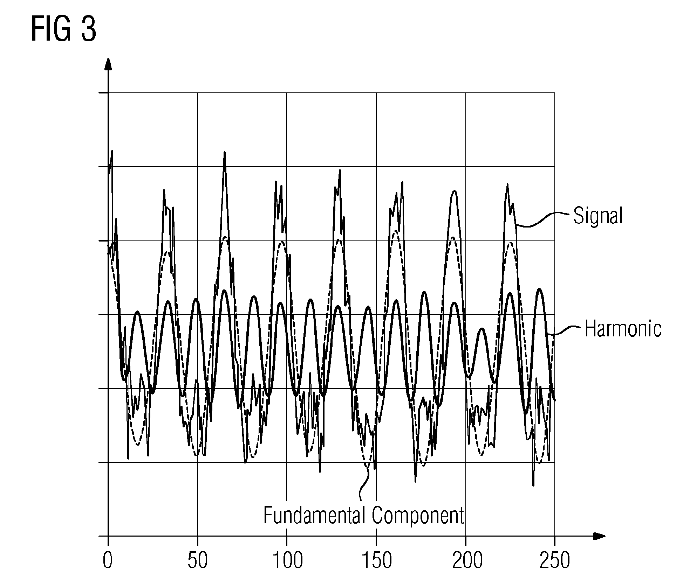

Reference is now made to Figs. 2 and 3.

Fig. 2 and 3 show a simulated example via a Matlabscript. The simulated signals are from two time series, the first from the oscillation due to striction and the second from a Stokes wave. The striction case resembles that of square waveform and therefore exhibit odd harmonics. The stoke wave consists of even harmonics.

The signals so formed and the components IMF for both the test cases are shown in Figures 1 and 2, respectively. The method successfully determines the presence of harmonics without any a priori assumption about data or underlying dynamics.

The method is equally applicable to the plant data with nonlinear and non-stationary effects. The method is adaptive in nature and doesn't require any a priori knowledge about underlying plant dynamics.

Although the invention has been illustrated and described in detail, the invention is not limited by the disclosed examples. A person skilled in the art can derive variations without departing the scope of the invention.

**Claims**

1. Method for detection of harmonics of a univariate signal (X), comprising the steps of:

   making (S100) at least a trivariate signal (Y) with at least three channels by appending the univariate signal (X) with at least two channel zero mean uncorrelated Gaussian noise,
   decomposing (S200) each channel into N components (IMF) by processing the signal (Y) using multivariate empirical mode decomposition (MEMD),
   calculating (S300) the Auto covariance function (ACF) of the components (IMF),
   analysing (S400) the Auto covariance functions (ACF) to determine zero crossings of each Auto covariance function (ACF) and determine mean time periods (Tp) of the oscillations,
   calculating (S500) at least one base frequency ('$\Omega$') using the mean time period (TP), and calculate at least one maximum frequency ('$\Omega_{max}$') and a minimum frequency ('$\Omega_{min}$'), using at least the base frequency ('$\Omega$'), and
   identifying (S600) whose component (IMF'), which has the largest correlation with the signal (X).

2. Method according to claim 1, comprising the step of

   retaining (S220) the components (IMF) corresponding to the signal (X) and/or discard the components (IMF) corresponding to the at least two noise channels.

3. Method according to claim 1 or 2, comprising the step of calculating (S320) correlation coefficients ($\rho_i$) of each component (IMF) with the corresponding signal (X),
   calculating (S340) corresponding normalized correlation coefficients ($\lambda_i$) using the correlation coefficient ($\rho_i$),
   comparing (S360) the normalized correlation coefficients ($\lambda_i$) with a threshold ($\eta$), and retain those components (IMF) for which normalized correlation coefficients ($\lambda_i$) are equal or larger than the threshold ($\eta$),
   determine (S370) a sparseness (S) for all retained components (IMF), and compare each sparseness (S) with a second threshold (th), and retain those components (IMF) for which the sparseness (S) is higher than the second threshold (th), and
   calculating (S380) the Auto covariance function (ACF) on the basis of the retained components (IMF).

4. Method according to one of the claim 1 to 3, comprising the step of:

determining (S420) the regularity (r) of the oscillations (OSC) by analysing at least the mean time period (TP), and comparing (S440) the regularity (r) with a limit (l), and retain those mean time periods (TP) for which the regularity (R) is greater than the limit (l).

5. Method according to claim 4, comprising the step of:

multiply (S620) a corresponding frequency ($\Omega_{\lambda max}$) of the identified component (IMF') with am integer k, take (S640) a respective maximum frequency and minimum frequency of another component (IMF), and compare the integer multiples with the respective maximum frequency and minimum frequency of the other component (IMF), and consider the frequency as harmonic (H), if the integer multiples lies within the respective maximum frequency and minimum frequency of the other component (IMF), and comparing (S660) the correlation coefficients of the identified component (IMF') with one correlation coefficient of at least one other component (IMF), and consider the identified component (IMF') and the other component (IMF) as harmonic pair (HP), if the correlation coefficients of the identified component (IMF') is higher than the correlation of the other component (IMF).

6. Method according to claim 5, comprising the step of

comparing the correlation coefficients of the other component (IMF) with one correlation coefficient of one further other component, and consider the other component (IMF) and the other component as harmonic, if the correlation coefficients of the other component (IMF) is higher than the correlation of the further other component.

7. Software product, comprising modules configured to perform a method according to one of the claims 1 to 6.

8. Device for detection of harmonics of a univariate signal (X), wherein the device is configured to

making (S100) at least a trivariate signal (Y) with at least three channels by appending the univariate signal (X) with at least two channel zero mean uncorrelated Gaussian noise, decomposing (S200) each channel into N components (IMF) by processing the signal (Y) using multivariate empirical mode decomposition (MEMD), calculating (S300) the Auto covariance function (ACF) of the components (IMF), analysing (S400) the Auto covariance functions (ACF) to determine zero crossings of each Auto covariance function (ACF) and determine mean time periods (Tp) of the oscillations, calculating (S500) at least one base frequency ('$\Omega$) using the mean time period (TP), and calculate at least one maximum frequency ('$\Omega_{max}$) and a minimum frequency ('$\Omega_{min}$), using at least the base frequency ('$\Omega$), and identifying (S600) whose component (IMF'), which has the largest correlation with the signal (X).

9. Device according to claim 8, wherein the device is configured to

retaining (S220) the components (IMF) corresponding to the signal (X) and/or discard the components (IMF) corresponding to the at least two noise channels.

10. Device according to claim 8 or 9, wherein the device is configured to

calculating (S320) correlation coefficients ($\rho_i$) of each component (IMF) with the corresponding signal (X), calculating (S340) corresponding normalized correlation coefficients ($\lambda_i$) using the correlation coefficient($\rho_i$), comparing (S360) the normalized correlation coefficients ($\lambda_i$) with a threshold ($\eta$), and retain those components (IMF) for which normalized correlation coefficients ($\lambda_i$) are equal or larger than the threshold ($\eta$), determine (S370) a sparseness (S) for all retained components (IMF), and compare each sparseness (S) with a second threshold (th), and retain those components (IMF) for which the sparseness (S) is higher than the second threshold (th), and calculating (S380) the Auto covariance function (ACF) on the basis of the retained components (IMF).

11. Device according to one of the claim 8 to 10, wherein the device is configured to

determining (S420) the regularity (r) of the oscillations (OSC) by analysing at least the mean time period (TP), and comparing (S440) the regularity (r) with a limit (l), and retain those mean time periods (TP) for which the regularity (r) is greater than the limit (l).

**12.** Device according to claim 11, wherein the device is configured to

multiply (S620) a corresponding frequency ($\Omega_{\lambda,max}$) of the identified component (IMF') with an integer k, take (S640) a respective maximum frequency and minimum frequency of another component (IMF), and compare the integer multiples with the respective maximum frequency and minimum frequency of the other component (IMF), and consider the frequency as harmonic (H), if the integer multiples lies within the respective maximum frequency and minimum frequency of the other component (IMF), and comparing (S660) the correlation coefficients of the identified component (IMF') with one correlation coefficient of at least one other component (IMF), and consider the identified component (IMF') and the other component (IMF) as harmonic pair (HP), if the correlation coefficients of the identified component (IMF') is higher than the correlation of the other component (IMF).

**13.** Device according to claim 12, wherein the device is configured to

comparing the correlation coefficients of the other component (IMF) with one correlation coefficient of one further other component, and consider the other component (IMF) and the other component as harmonic, if the correlation coefficients of the other component (IMF) is higher than the correlation of the further other component.

FIG 1

FIG 2

FIG 3

Europäisches
Patentamt

European
Patent Office

Office européen
des brevets

## EUROPEAN SEARCH REPORT

Application Number

EP 16 19 1144

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2008/065337 A1 (HUANG NORDEN E [US] ET AL) 13 March 2008 (2008-03-13) * abstract * * paragraphs [0002] - [0012], [0036] - [0068] * * figures 1-17 * | 1-13 | INV. G01R19/25 G06F17/14 |
| A | US 2015/293143 A1 (ZAO JOHN KAR-KIN [TW] ET AL) 15 October 2015 (2015-10-15) * abstract * * paragraphs [0003] - [0005], [0024] - [0044] * * figures 1-18 * | 1-13 | |
| A | US 6 115 685 A (INOUE AKIRA [JP] ET AL) 5 September 2000 (2000-09-05) * abstract * * column 2, line 44 - column 10, line 37 * * figures 1-12 * | 1-13 | |

TECHNICAL FIELDS
SEARCHED      (IPC)

G01R
H04B
G06F

The present search report has been drawn up for all claims

| Place of search | Date of completion of the search | Examiner |
|---|---|---|
| Munich | 13 March 2017 | Aquilani, Dario |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 16 19 1144

This annex lists the patent family members relating to the patent documents cited in the above-mentioned European search report.
The members are as contained in the European Patent Office EDP file on
The European Patent Office is in no way liable for these particulars which are merely given for the purpose of information.

13-03-2017

| Patent document cited in search report | Publication date | Patent family member(s) | Publication date |
|---|---|---|---|
| US 2008065337 A1 | 13-03-2008 | NONE | |
| US 2015293143 A1 | 15-10-2015 | NONE | |
| US 6115685 A | 05-09-2000 | JP H11219198 A<br>US 6115685 A | 10-08-1999<br>05-09-2000 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Signal Processing. *IEEE Transactions on Signal Processing,* 2011, vol. 59 (5), 2421-2426